# EUROPEAN PATENT SPECIFICATION

(11) **EP 2 236 018 B1**
(45) Date of publication and mention of the grant of the patent: **28.11.2012**
(21) Application number: 08869099.5
(22) Date of filing: 12.12.2008
(51) Int. Cl.: H05K 9/00

(54) **MAGNETIC SHIELDING GASKET**
MAGNETSCHIRMDICHTUNG
JOINT STATIQUE DE PROTECTION MAGNETIQUE

(30) Priority: 29.12.2007 CN 200710308149
(43) Date of publication of application: 06.10.2010
(73) Proprietor: 3M Innovative Properties Company, Saint Paul, MN 55133-3427 (US)
(72) Inventor: LIU, Wei De, 200336 Shanghai (CN)
(74) Representative: Isarpatent
(86) International application number: PCT/US2008/086590
(87) International publication number: WO 2009/085660

(56) References cited:
- EP-A1- 1 272 024
- WO-A1-94/13123
- WO-A1-03/030610
- WO-A1-03/034800
- KR-A- 20040 089 379
- US-A- 3 969 572
- US-A- 4 496 627
- US-A1- 2005 045 358
- US-A1- 2006 180 348
- US-B1- 6 309 742
- US-B2- 6 784 363

## Description

### Field of the Invention

The present invention relates to an electromagnetic shield technology, particularly, to a magnetic shielding gasket for shielding the Electro Magnetic Interference (EMI)/Radio Frequency Interference (RFI). In addition, the present invention also relates to a method of filling a gap in an EMI shielded system.

### Background

Electro Magnetic Interference (EMI) is an undesired electromagnetism generated in or radiated from an electronic/electric apparatus, which may disadvantageously affect the normal operations of the electronic/electric apparatus. Generally, such Electro Magnetic Interference may occur at any frequency band of the electromagnetic frequency spectrum. Furthermore, Radio Frequency Interference (RFI) often occurs accompanying with Electro Magnetic Interference (EMI). In practice, Radio Frequency Interference (RFI) is controlled to happen at the Radio Frequency of the electromagnetic frequency spectrum, that is, at a frequency band from 10 KHz to 100 GHz.

In order to effectively prevent Electro Magnetic Interference (EMI)/Radio Frequency Interference (RFI), generally, a shield is disposed between the source of EMI/RFI and the region to be protected. The shield is used for preventing the electromagnetic energy from being radiated out of the source of EMI/RFI, and also for preventing the outer electromagnetic energy from entering into the source of EMI/RFI.

Commonly, the shield is formed in a conductive seal shell that may be grounded via a ground wire on PCB. In prior art, the conductive seal shell may be integrally made of a magnetic shielding gasket material. In addition, in practice, according to the requirement from the inner circuit or structure, a groove may be provided in the conductive seal shell so as to form a gap in the shield. In this case, the gap formed in the shield may be filled with a shielding gasket so as to prevent the electromagnetic energy from being radiated out of the source of EMI/RFI, and also to prevent the outer electromagnetic energy from entering into the electronic/electric apparatus.

Recently, the electronic/electric apparatuses, such as mobile telephone, PDA, and navigation system, are becoming more compact and with better portability. On the one hand, in order to prevent the dust or moisture from entering into the core parts, such as LCD modules, of these communication equipments, and to prevent the impaction and vibration to the core parts due to bump or fall during carrying or delivering, it is needed to provide an absorption gasket material with high impact and vibration absorptivity outside these electronic modules of the electronic/electric apparatus. Such absorption gasket material generally is made of an open-celled material, such as polyurethane foam, so that the absorption gasket material has certain resilience and recoverability. On the other hand, since the LCD modules of these electronic communication equipments are required to have larger screen and multi-functions such as character or picture communication function, and photographing function, the circuits and electronic modules in the electronic/electric apparatus become sensitive to the exterior static electricity, electromagnetic wave, and magnetic field, and tend to be disadvantageously affected by the inner and outer sources of Electro Magnetic Interference/Radio Frequency Interference.

Thus, not only the absorption gasket material of aforesaid electronic/electric apparatus need have a high impact and vibration absorptivity, but also have a gapless seal capability in a narrow space of the electronic/electric apparatus and a good shielding capability to Electro Magnetic Interference (EMI)/Radio Frequency Interference (RFI) generated in or outside the electronic/electric apparatus.

US 6,309,742 discloses a magnetic shielding gasket formed by depositing a metal coating onto an open-celled foam structure such as a silicone rubber. Since the deposited metal material penetrates the open-celled foam structure so that the open-celled foam structure has an excellent conductivity. Accordingly, the gasket material is die-cut into or cut into various shapes or shaped into a shielding structure, and then filled in or covered around the electronic/electric apparatus so as to shield Electro Magnetic Interference (EMI)/Radio Frequency Interference (RFI) generated in or outside the electronic/electric apparatus by means of its conductivity.

The document US3969572 'Electromagnetic interference shielding gasket for light-weight equipment enclosures' - ROSTEK PAUL - Published on 13-7-1976 discloses as well a low cost electromagnetic interference (EMI) gasket for light-weight equipment enclosures, where a pliable strip of electrically conductive material is wrapped spirally about a flexible laminar core structure comprising foam and permanent magnet elements.

However, the above-mentioned prior art has following disadvantages. Firstly, although the gasket material of prior art has certain conductivity and has good shielding effect on the static electricity and magnetic field, the gasket material has poor shielding effect on the magnetic field generated in or outside the electronic/electric apparatus, particularly, on the near field magnetic field. Secondly, although the gasket material of prior art has good resilience and recoverability, the mechanical strength of gasket material is very low for it is only formed of the open-celled foam structure, increasing the difficulty in cutting or die-cutting out the gasket material to predetermined shape and also increasing difficulty of performing the cutting or die-cutting operation. Also, it is very difficult to locate the gasket material on the predetermined electronic module of the electronic/electric apparatus.

### Summary

The present inventors have determined that it is desirable to provide a magnetic shielding gasket that not only can effectively shield the electric field and magnetic field, but also has sufficient resilience, recoverability and mechanical strength so as to obtain an excellent sealing performance while improving the operability during cutting and locating the gasket material and the efficiency during machining and assembling.

The present invention is directed to solve at least one aspect of the aforesaid problems existing in the prior art.

One aspect of the present invention is to provide a magnetic shielding gasket having magnetic permeability, which can effectively shield the electric field and has a satisfactory magnetic field shielding performance.

Another aspect of the present invention is to provide a magnetic shielding gasket comprising a structure reinforcing layer to achieve a satisfied mechanical strength, thereby improving the operability during cutting and locating the gasket material and the efficiency during machining and assembling.

Another aspect of the present invention is to provide a method of filling a gap in an EMI shielded system with aforesaid magnetic shielding gasket material.

One embodiment of the present invention is to provide a magnetic shielding gasket according to claim 1.

An example useful to understand the present invention is a magnetic shielding gasket, comprising: a conductive foam substrate exhibiting resilience and recoverability and having a surface; a structure reinforcing layer made of conductive fabric, said structure reinforcing layer being attached to said surface of the conductive foam substrate; and a magnetic layer attached to an outer surface of the structure reinforcing layer and wherein the magnetic layer exhibits high magnetic permeability, wherein the initial magnetic permeability of the magnetic layer is greater than 1000 @ 0.1A/m and the maximum magnetic permeability of the magnetic layer is greater than 5000 @ 0.1A/m. In one preferred embodiment, the initial magnetic permeability of the magnetic layer is greater than 35,000 @ 0.1A/m and the maximum magnetic permeability of the magnetic layer is greater than 200,000@ 0.1A/m.

In another example, the initial magnetic permeability of the magnetic layer is greater than 50,000 @ 0.1A/m and the maximum magnetic permeability of the magnetic layer is greater than 300,000@ 0.1A/m.

In another example, the initial magnetic permeability of the magnetic layer is greater than 80,000 @ 0.1A/m and the maximum magnetic permeability of the magnetic layer is greater than 400,000@ 0.1A/m.

In a further preferred embodiment, the conductive foam substrate further includes a second surface opposite to said first surface; and a structure reinforcing layer made of conductive fabric is attached to said second surface of the conductive foam substrate.

In an alternative embodiment, the magnetic shielding gasket further comprises a structure reinforcing layer made of conductive fabric, said structure reinforcing layer being attached to an outer surface of said magnetic layer.

With the magnetic shielding gasket, the present invention can effectively shield the electric field and magnetic field, particularly, the near field magnetic field. Meanwhile, since it has appropriate resilience, recoverability and mechanical strength, the magnetic shielding gasket can obtain an excellent sealing performance while improving the operability during cutting and locating the gasket material, and the efficiency during machining and assembling.

### Brief Description of the Drawings

Fig. 1 is a view showing the structure of the magnetic shielding gasket according to an embodiment of the present invention, wherein in Fig.1A is a perspective view illustrating the construction of the magnetic shielding gasket, and Fig.1B is a cross-sectional view of the magnetic shielding gasket.
Fig. 2 is a view showing the structure of the magnetic shielding gasket according to another embodiment of the present invention;
Fig. 3 is a view showing the structure of the magnetic shielding gasket according to a further embodiment of the present invention;
Fig. 4 is a view showing the structure of the magnetic shielding gasket according to a further another embodiment of the present invention;
Fig. 5 is an illustration showing the shielding effect of seal structure of the magnetic shielding gasket according to the present invention;
Fig. 6 is a contrastive illustration showing the shielding effect of the magnetic shielding gasket of the present invention applied on the Printed Circuit Board (PCB), wherein Fig. 6A is an illustration showing the shielding effect of the Printed Circuit Board (PCB) on which no magnetic shielding gasket is mounted; Fig. 6B is an illustration showing the shielding effect of the Printed Circuit Board (PCB) on which the magnetic shielding gasket is mounted;
Fig. 7 is a graph showing the experiment data of the shielding effect of the magnetic shielding gasket according to the present invention.
Fig. 8 is a graph illustrating hysteresis loop of the magnetic layer according to an embodiment of the present invention.
Fig. 9 is schematic view of a typical application of the magnetic shielding gasket according to the present invention.

### Detailed Description

Preferred embodiments of the present invention will be described hereinafter in detail with reference to the attached drawings, wherein the like reference numerals refer to the like elements throughout the specification. The present invention may, however, be embodied in many different forms and should not be construed as being limited to the embodiment set forth herein; rather, this embodiment is provided so that the present disclosure will be thorough and complete, and will fully convey the concept of the invention to those skilled in the art.

### Embodiment 1

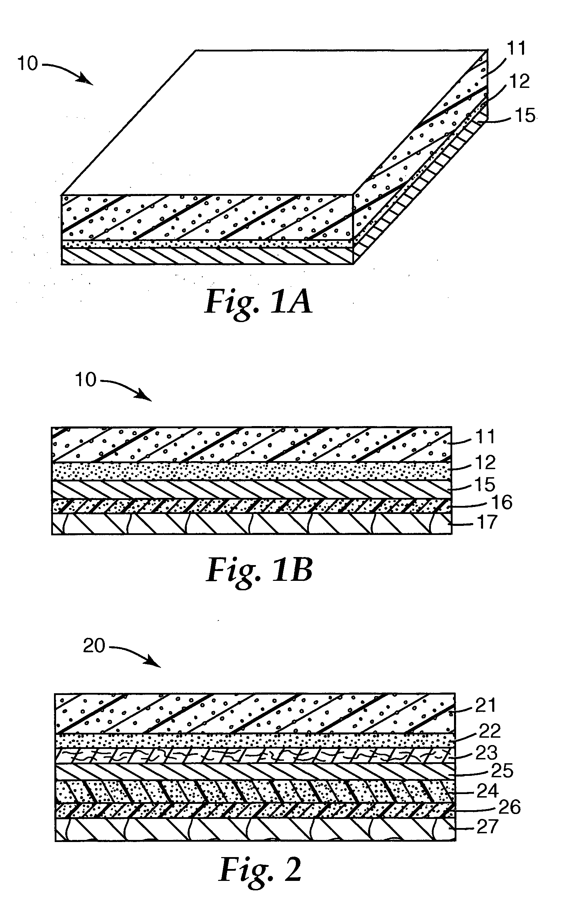

Fig.1 is a view showing the structure of the magnetic shielding gasket according to an embodiment of the present invention. As shown in Fig.1, the magnetic shielding gasket 10 includes a conductive foam substrate 11 and a magnetic layer 15 attached to the conductive foam substrate 11. In this embodiment, the conductive foam substrate 11 is made of a material having resilience and recoverability and has an upper surface and a lower surface (for simplification, the surface on upper side of the drawing is defined as the upper surface; the surface on lower side of the drawing is defined as the lower surface, referring to the same hereinafter). The magnetic layer 15 is attached to one surface, for example, the lower surface shown in Fig.1, of the conductive foam substrate 11. The magnetic layer 15 exhibits magnetic permeability, wherein the initial magnetic permeability of the magnetic layer 15 is greater than 1000 @ 0.1A/m and the maximum magnetic permeability of the magnetic layer 15 is greater than 5000 @ 0.1A/m.

In an embodiment, the conductive foam substrate 11 is an open-celled foam that is made of a resilient macromolecule material, such as polyurethane, by the expanding or foaming process and has good resilience. The conductive foam substrate 11, however, is not limited to above material, it may be made of any one resilient material that has predetermined recoverability upon an external force is applied, for example, it may be macromolecule synthetic resin foam such as polyurethane, polyvinyl chloride (PVC), silicone, ethylene-vinyl-acetate copolymer (EVA) bend, and polyethylene etc.

On the one hand, for having good impaction absorptivity and anti-vibration, and for achieving an excellent sealing performance during pressing the magnetic shielding gasket 10 into the predetermined gap, the conductive foam substrate 11 should exhibit compressibility during an external force is applied thereon.

On the other hand, the conductive foam substrate 11 also should exhibit suitable recoverability when the external force is removed. In an embodiment, the magnetic shielding gasket 10 having aforesaid conductive foam substrate 11 is substantially deformable with less than 50 psi of pressure and substantially recoverable after the pressure is removed. Further, after the pressure is removed, the gasket 10 is able to recover at least 10% of the amount it is compressed. In a preferred embodiment, after the pressure is removed, the gasket10 is able to recover at least 30% of the amount it is compressed. In a preferred embodiment, after the pressure is removed, the gasket10 is able to recover at least 70% of the amount it is compressed.

The open-celled foam structure has a pore density of 50-250ppi, preferably 60-150ppi, and more preferably 80-120ppi. In order to have good conductivity, the conductive foam substrate 11 is formed by depositing a metal coating onto the open-celled foam structure via a vacuum evaporation coating process, an electroplating process or chemical plating process. Since the open-celled foam structure has a plurality of pores, after depositing a metal coating onto the open-celled foam structure, the conductive foam substrate 11 is not only conductive on the surface thereof, but also conductive in vertical direction and other directions thereof, so as to form a continuously conductive open-celled foam structure in three-dimensions.

The method for depositing a metal coating onto the conductive foam substrate 11 may includes at least one of the vacuum evaporation coating process, electroplating process or chemical plating process. The metal coating comprises at least one of Cu, Ni, Sn, Au, Ag, Co and Pd and the mixture thereof. In one embodiment, the metal coating may be Ni-coating + Cu-coating + Ni-coating, Ni-vacuum evaporation coating + Ni-electroplating, chemical catalyst coating + Cu-chemical plating + Ni-electroplating, Ni-coating + Cu-coating + Sn-coating, chemical catalyst coating + Cu-chemical plating + Sn-electroplating.

The metal coating deposited onto the conductive foam substrate 11 has a thickness of 0.5-10mm, preferably 1.0-3.0mm, more preferably 1.5-2.0mm.

In one preferred embodiment, the conductive foam substrate 11 has a thickness of 1.6mm and a pore density of 110ppi. Using Ni-vacuum evaporation coating process + Ni-electroplating process, the metal coating is deposited onto the conductive foam substrate 11. The Ni-vacuum evaporation coating has an average thickness less than 0.01 mm and a density of 0.3-0.4 g/m², and the Ni-electroplating has an average thickness equal to 1 mm and a density of 15-20 g/m².

The magnetic layer 15 may be made of at least one high permeability alloy ribbon of the group consisting of permalloy ribbon, nanocrystalline iron-based alloy ribbon, and Co-based amorphous alloy ribbon. The magnetic layer 15 having aforesaid material exhibits excellent conductivity and high magnetic permeability. Accordingly, the initial magnetic permeability of the magnetic layer 15 is greater than 1000 @ 0.1A/m and the maximum magnetic permeability of the magnetic layer 15 is greater than 5000 @ 0.1A/m. With the above high value of magnetic permeability of the magnetic layer 15, the magnetic field of the EMI/RFI source, particularly, the near-field EMI source tends to be easily conducted through the magnetic layer 15, thus effectively shielding the interference from the near-field EMI source.

In one embodiment, the initial magnetic permeability of the magnetic layer 15 is greater than 35,000 @ 0.1A/m and the maximum magnetic permeability of the magnetic layer 15 is greater than 200,000 @ 0.1A/m. In one preferred embodiment, the initial magnetic permeability of the magnetic layer 15 is greater than 50,000 @ 0.1A/m and the maximum magnetic permeability of the magnetic layer 15 is greater than 300,000 @ 0.1A/m. In one more preferred embodiment, the initial magnetic permeability of the magnetic layer 15 is greater than 80,000 @ 0.1A/m and the maximum magnetic permeability of the magnetic layer 15 is greater than 400,000 @ 0.1A/m.

The magnetic layer 15 may be formed by at least one of the rolling, chemical deposing, and vacuum evaporation coating. The magnetic layer 15 has a thickness of 10-100 µm, preferably 15-30 µm.

In one preferred embodiment, the magnetic layer 15 may be made of a FeNi-based alloy ribbon with excellent conductivity and high magnetic permeability, wherein the content of Ni is larger than 30%w, preferably larger than 50%w, more preferably larger than 80%w. In this embodiment, the content of Ni is 60%w. The magnetic layer 15 is formed by the chemical deposing process and has a thickness of about 20 µm. After the chemical deposing process, the magnetic layer with high magnetic permeability may be further treated by an annealing process so as to obtain good magnetic permeability and metal plasticity. In this embodiment, the initial magnetic permeability of the magnetic layer 15 is greater than 53,000 @ 0.1A/m and the maximum magnetic permeability of the magnetic layer 15 is greater than 460,000 @ 0.1A/m.

The magnetic layer 15 is attached to the conductive foam substrate 11 by an adhesive. The adhesive may be a conductive adhesive or a non-conductive adhesive. If the non-conductive adhesive is used, the electric field shielding effect of the magnetic shielding gasket 10 may be influenced to some extent. As shown in Fig.1, preferably, the magnetic layer 15 is attached onto the conductive foam substrate 11 by the conductive adhesive.

Alternatively, as shown in Fig.1, a liner 17 is disposed onto an outer surface of the magnetic layer 15 by a conductive adhesive 16 such as a black adhesive tape. In this way, if the magnetic shielding gasket 10 is to be placed on a predetermined position of the PCB, it is only needed to peel the liner from the outer surface of the magnetic layer 15, and then simply attach the magnetic shielding gasket 10 onto the PCB by means of the conductive adhesive on outer surface of the magnetic layer 15, thus, improving the installation and position efficiency of magnetic shielding gasket 10.

The attachment between the conductive foam substrate 11, magnetic layer 15 and liner 17 may be accomplished by the normal temperature film attaching, normal temperature jointing, thermal melt film attaching, or continuously thermal pressing. In one preferred embodiment, for further promoting the conductivity, the attachment between the conductive foam substrate 11, magnetic layer 15 and liner 17 is accomplished by the normal temperature conductive adhesive film attaching.

### Embodiment 2

Fig. 2 shows the structure of the magnetic shielding gasket 20 according to another embodiment of the present invention. Compared with Embodiment 1, the Embodiment 2 differs in that the magnetic shielding gasket 20 additionally includes a structure reinforcing layer 23 between the conductive foam substrate 21 and magnetic layer 25. The conductive foam substrate 21 and magnetic layer 25 of Embodiment 2 are similar or same to the conductive foam substrate 11 and magnetic layer 15 of Embodiment 1, respectively. For purpose of clarity and simplification, only the structures, parts and features different from Embodiment 1 are described in this specification, and the similar or same structures, parts and features are omitted.

As shown in Fig.2, the magnetic shielding gasket 20 from the outside towards inside sequentially comprises: a conductive foam substrate 21 exhibiting resilience and recoverability and having upper and lower surfaces; a structure reinforcing layer 23 made of conductive fabric and attached to the lower surface of the conductive foam substrate 21; and a magnetic layer 25 attached to an outer surface of the structure reinforcing layer 23.

Similar to Embodiment 1, the structure reinforcing layer 23 is attached onto the conductive foam substrate 21 by a conductive adhesive 22; the magnetic layer 25 is attached onto the outer surface of the structure reinforcing layer 23 by a conductive adhesive 24. Alternatively, the liner 27 is disposed onto the outer surface of the magnetic layer 25 by a conductive adhesive 26 such as a black adhesive tape.

Identical to Embodiment 1, the magnetic layer of Embodiment 2 also exhibits high magnetic permeability, wherein the initial magnetic permeability of the magnetic layer is greater than 10 @ 0.1A/m and the maximum magnetic permeability of the magnetic layer is greater than 10 @ 0.1 A/m.

The structure reinforcing layer 23 is made of conductive fabric so as to have good conductivity and suitable mechanical strength. The conductive fabric may be formed by a mesh fabric constructed by a macromolecule compound, such as knitting fibers of PET material, and the knitting tightness is in the range of 100-350T, preferably 150-260T. The structure reinforcing layer 23 has a thickness of 0.05-0.15mm, preferably 0.05-0.09mm. After the chemically pre-processing, chemically Cu-depositing, and Ni-electroplating, the mesh fabric is formed into a continuously uniform conductive fabric. The surface resistivity of the structure reinforcing layer 23 is not greater than 0.5 ohm/sqr, preferably not greater than 0.1 ohm/sqr, more preferably not greater than 0.05 ohm/sqr. In one preferred embodiment, the surface resistivity of the structure reinforcing layer 23 is not greater than 0.03 ohm/sqr.

In one preferred embodiment, the structure reinforcing layer 23 has a knitting tightness of 220T and a thickness of 0.06mm. In one preferred embodiment, the mechanical strength of the structure reinforcing layer 23 is larger than 18Kg/in.

In the present invention, by additionally providing a structure reinforcing layer 23, the mechanical strength of the magnetic shielding gasket 20 is increased, thus, improving the operability during cutting or dieing out the magnetic shielding gasket material to predetermined shape and the efficiency during machining. Meanwhile, the operation to locate the gasket material on the predetermined electronic module of the electronic/electric apparatus will become easier and simpler.

### Embodiment 3

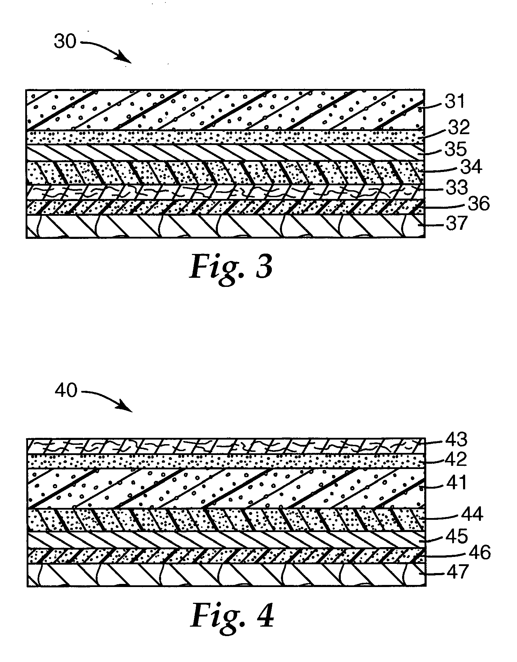

Fig. 3 shows the structure of the magnetic shielding gasket 30 according to another embodiment of the present invention. The magnetic shielding gasket 30 of Embodiment 3 is substantively same to the magnetic shielding gasket 10 of Embodiment 1. Compared with Embodiment 1, the Embodiment 3 differs in that a structure reinforcing layer 33 is additionally provided on the magnetic layer 35. The structure reinforcing layer 33 of Embodiment 3 is similar or identical to the structure reinforcing layer 23 of Embodiment 2. The conductive foam substrate 31 and magnetic layer 35 of Embodiment 3 are similar or identical to the conductive foam substrate 11 and magnetic layer 15 of Embodiment 1, respectively. For purpose of clarity and simplification, only the structures, parts and features different from Embodiments 1 and 2 are described in this specification, and the similar or same structures, parts and features are omitted.

As shown in Fig.3, the magnetic shielding gasket 30 comprises: a conductive foam substrate 31 exhibiting resilience and recoverability and having upper and lower surfaces; a magnetic layer 35 attached to the lower surface of the conductive foam substrate 31; and a structure reinforcing layer 33 attached to the outer surface of the magnetic layer 35;

Similar to Embodiments 1 and 2, the magnetic layer 35 is attached to the conductive foam substrate 31 by a conductive adhesive 32; the structure reinforcing layer 33 is attached to the outer surface of the magnetic layer 35 by a conductive adhesive 34. Substitutively, the liner 37 is disposed onto the outer surface of the magnetic layer 35 by a conductive adhesive 36 such as the black adhesive tape.

### Embodiment 4

Fig. 4 shows the structure of the magnetic shielding gasket 40 according to another embodiment of the present invention. The magnetic shielding gasket 40 of Embodiment 4 is substantively same to the magnetic shielding gasket 30 of Embodiment 3. Compared with Embodiment 3, the Embodiment 4 differs in that a structure reinforcing layer 43 is not provided on one side of the magnetic layer 45, but on one side of the conductive foam substrate 41. The conductive foam substrate41, structure reinforcing layer 43 and magnetic layer45 of Embodiment 4 are similar or identical to the conductive foam substrate 31, structure reinforcing layer 33 and magnetic layer 35 of Embodiment 3, respectively. For purpose of clarity and simplification, only the structures, parts and features different from Embodiment 3 are described in this specification, and the similar or same structures, parts and features are omitted.

As shown in Fig.4, the magnetic shielding gasket 40 comprises: a conductive foam substrate 41 exhibiting resilience and recoverability and having upper and lower surfaces; a magnetic layer 45 attached to the lower surface of the conductive foam substrate 41; and a structure reinforcing layer 43 made of conductive fabric and attached to the upper surface of the conductive foam substrate 41.

Similar to Embodiments 1 and 2, the magnetic layer 45 is attached to the conductive foam substrate 41 by a conductive adhesive 44; the structure reinforcing layer 43 is attached to the outer surface of the magnetic layer 45 by a conductive adhesive 42. Alternatively, the liner 47 is disposed onto the outer surface of the magnetic layer 45 by a conductive adhesive 46 such as a black adhesive tape.

The actual application and effect of the magnetic shielding gasket according to the present invention will be described hereinafter.

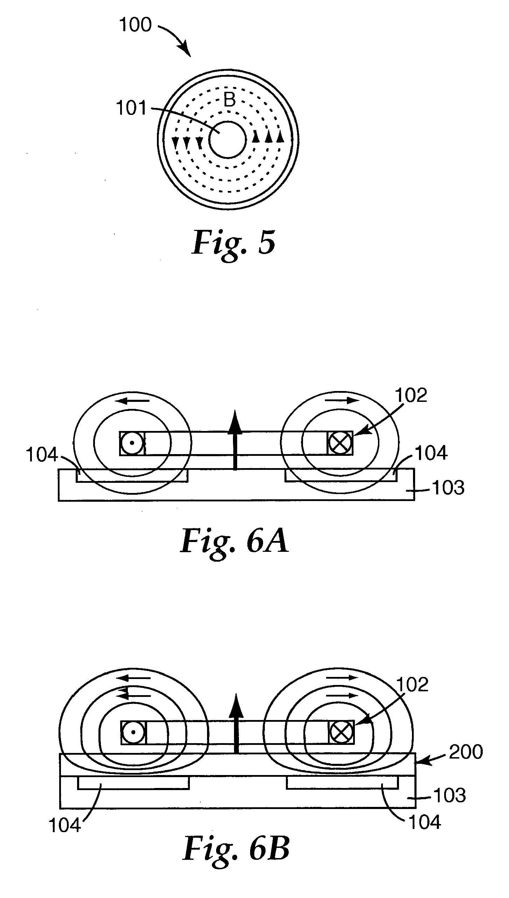

Fig.5 is a graph showing the shielding effect of seal structure of the magnetic shielding gasket according to the present invention. As shown in Fig.5, the magnetic shielding gasket 10, 20, 30 or 40 according to the present invention is formed to a sealing shield 100 to surround a source 101 of Electro Magnetic Interference/Radio Frequency Interference. Since the magnetic shielding gaskets 10, 20, 30 and 40 according to the present invention have good conductivity and magnetic permeability, the electromagnetic energy, such as magnetic field B, emitted by the source 101 of Electro Magnetic Interference/Radio Frequency Interference is effectively shielded by the sealing shield 100.

Fig.6 is a contrastive illustration showing the shielding effect of the magnetic shielding gasket of the present invention applied on the Printed Circuit Board (PCB), wherein Fig. 6A is an illustration showing the shielding effect of the Printed Circuit Board (PCB) on which no magnetic shielding gasket is mounted; Fig. 6B is an illustration showing the shielding effect of the Printed Circuit Board (PCB) on which the magnetic shielding gasket is mounted.

As shown in 6A, a plurality of electron/electric parts, such as two parts 104, 104, are provided on the PCB 103. A Near-Field EMI/EFI source 102 is provided near the parts 104, 104. As shown in 6A, the electromagnetic energy, such as magnetic field B, emitted by the Near-Field EMI/EFI source 102 will affect and interfere with the operation of the parts 104, 104 when no magnetic shielding gasket is provided on the PCB 103. As shown in 6B, a plurality of electron/electric parts, such as two parts 104, 104, are provided on the PCB 103. A Near-Field EMI/EFI source 102 is provided near the parts 104, 104. As shown in 6B, the electromagnetic energy, such as magnetic field B, emitted by the Near-Field EMI/EFI source 102 will be effectively shielded when the magnetic shielding gasket 200 is provided on the PCB 103.

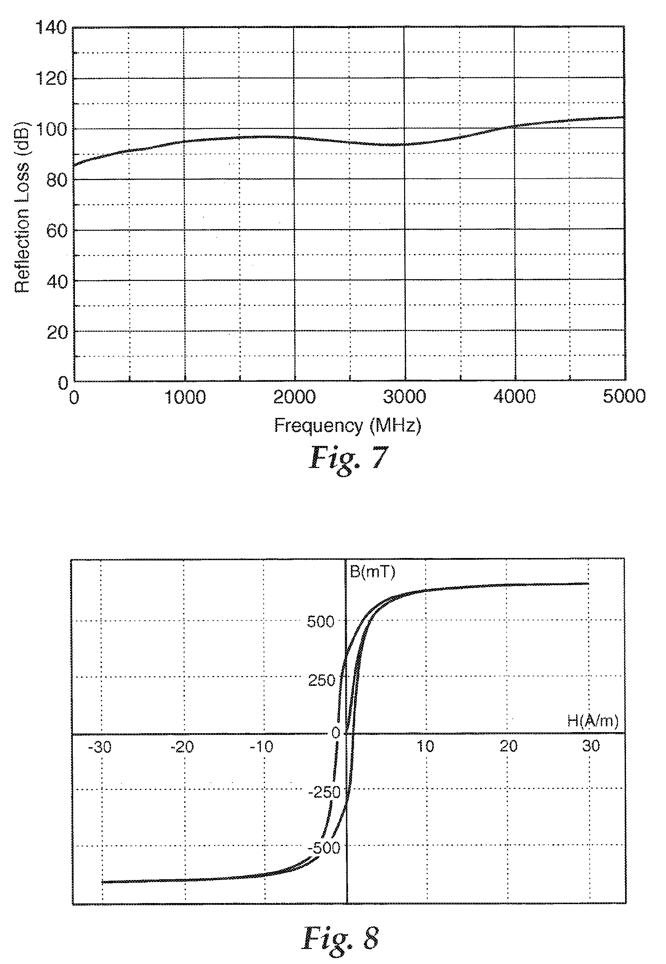

Fig.7 is a graph showing the experiment data of the shielding effect of the magnetic shielding gasket according to the present invention. When setting the electromagnetic wave frequency in the range of 30MHz-5GHz and measuring based on ASTM D4935-99, the electromagnetic shielding effect of the magnetic layer 15, 25, 35 or 45 according to the present invention is greater than 90 dB, the electromagnetic shielding effect of conductive structure reinforcing layer according to the present invention is greater than 80 dB, and the electromagnetic shielding effect of the conductive foam substrate 11, 21, 31 or 41 compressed to the stop point according to the present invention is greater than 80 dB. As shown in Fig.7, when measuring based on ASTM D4935-99, the shielding effect of the magnetic shielding gasket 10, 20, 30 or 40 according to various embodiments of the present invention is greater than 80 dB.

The measuring method and the measuring results on performance parameters of the magnetic shielding gasket 10, 20, 30 or 40 according to various embodiments of the present invention will be described hereinafter.

For measuring the compression ratio of the magnetic shielding gasket according to the present invention, the initial thickness and the limit compression thickness of the magnetic shielding gasket 10, 20, 30 or 40 are defined as d1 and d3, respectively, then the compression ratio R can be expressed as R=(d1-d3)/d1*100%. In one sample of the magnetic shielding gasket 10, 20, 30 or 40, the initial thickness d1 of the magnetic shielding gasket 10, 20, 30 or 40 measured by Mitutoyo digital display caliper is 1.8mm+/- 0.25mm. The limit compression thickness d3, which is measured in case where a pressure is applied on the magnetic shielding gasket 10, 20, 30 or 40 within the range of less than 50PSI, is 0.3-0.4mm. According to aforesaid formula, it will be easily obtained that the possible compression ratio of the magnetic shielding gasket 10, 20, 30 or 40 is larger than 75%.

On the other hand, the magnetic shielding gasket 10, 20, 30 or 40 can be substantially recoverable after aforesaid pressure that is applied within the range of less than 50PSI is removed. Further, after the pressure is removed, the magnetic shielding gasket 10, 20, 30 or 40 is able to recover at least 10% of the amount it is compressed. In one preferred embodiment, after the pressure is removed, the magnetic shielding gasket 10, 20, 30 or 40 is able to recover at least 30% of the amount it is compressed. In one still preferred embodiment, after the pressure is removed, the magnetic shielding gasket 10, 20, 30 or 40 is able to recover at least 70% of the amount it is compressed.

For measuring the residual deformation based on GB7759, ISO815, a tester composed of a parallel steel plate limiter and a fixing member is provided. The sample of the magnetic shielding gasket 10, 20, 30 or 40 according to the present invention is held between the parallel steel plates, and the compression amount is set to 50% of the initial thickness d1. After fixing the sample with the fixing member, place it in an oven at 70°C temperature for 22 hours, and then take out it, open the fixing member and dispose it in the air for 10 minutes, finally measure the thickness d2. Thus, the residual deformation D can be calculated according to the equation D=(d1-d2)/d1* 100%. As for aforesaid sample, the compression set is less than 20%.

For measuring the surface resistivity based on MIL-G-83528, a clip that weighs 250 gram is provided. The electrodes of the clip are treated with an Ag-deposited process. The contact dimension of the electrodes with the sample is 25.4mm*4.75mm, the space between the electrodes is 25.4 mm. After placing the electrodes on one surface of the sample of the magnetic shielding gasket 10, 20, 30 or 40, the resistance will be read out. Through test, the surface resistivity of the magnetic shielding gasket 10, 20, 30 or 40 according to the present invention is not greater than 0.05ohm/sqr.

For measuring the contact resistance of the magnetic shielding gasket 10, 20, 30 or 40 according to the present invention based on MIL-STD-202, a clip composed of two clipping blocks each having 1 inch area and a standard weight block is provided. During measuring, firstly to cut the sample of the magnetic shielding gasket 10, 20, 30 or 40 according to the present invention into square piece with a width and length both of 1 inch, then place the cut sample piece between the two clipping blocks and apply a pressure of, for example 2Kg, on the sample piece by the standard weight block, finally to read out the resistance between the two clipping blocks. Through test, the contact resistance of the magnetic shielding gasket 10, 20, 30 or 40 according to the present invention is not greater than 0.07ohm/square inch.

Fig. 8 is a graph illustrating hysteresis loop of the magnetic layer according to an embodiment of the present invention. For measuring the permeability of the magnetic layer according to the present invention based on IEC60404-6, the magnetic alloy ribbon material, such as permalloy ribbon, nanocrystalline iron-based alloy ribbon, and Co-based amorphous alloy ribbon, that serves as the magnetic layer 15, 25, 35 or 45 is cut with a width of 10mm, and then is rolled into a magnetic ring with an inner diameter of 20mm, an outer diameter of 32mm, and a duty ratio of larger than 70%. For example, with the MATS-2010SA tester, the test curve (that is, the hysteresis loop) as shown in Fig. 8 of the sample will be obtained when the initial magnetic field defined by the initial magnetic permeability is 0.1A/m. Through test, the initial magnetic permeability of the magnetic alloy ribbon material used in the magnetic layer 15, 25, 35 or 45 according to the present invention is greater than 1000 @ 0.1A/m, and the maximum magnetic permeability of it is greater than 5000@0.1A/m.

In one preferred embodiment, the initial magnetic permeability of the magnetic layer is greater than 35,000@0.1A/m, and the maximum magnetic permeability of it is greater than 200,000@0.1A/m. In one preferred embodiment, the initial magnetic permeability of the magnetic layer is greater than 50,000@0.1A/m, and the maximum magnetic permeability of it is greater than 300,000@0.1A/m. In one preferred embodiment, the initial magnetic permeability of the magnetic layer is greater than 80,000@0.1 A/m, and the maximum magnetic permeability of it is greater than 400,000@0.1A/m.

At last, the typical application of the magnetic shielding gasket 10, 20, 30 or 40 according to various embodiments of the present invention will be described hereinafter.

In one typical application, as shown in Fig.5, the magnetic shielding gasket 10, 20, 30 or 40 is formed to a sealing shield 100 to surround a source 101 of Electro Magnetic Interference/Radio Frequency Interference, and to shield the electromagnetic energy emitted by the source 101.

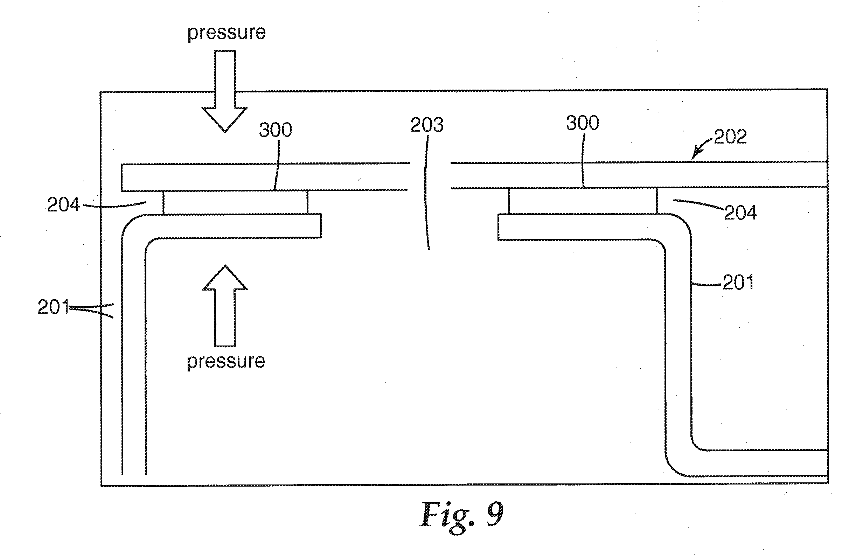

Fig. 9 is schematic view of another typical application of the magnetic shielding gasket according to the present invention. In the another typical application, in a shield system mainly composed of shielding members 201 and 202 , with the requirement of the inner circuit or structure, a groove 203 may be formed in the conductive seal structure so that a gap 204 is formed in the shield structure. In this case, the gap 204 may be filled with the magnetic shielding gasket 300 according to the present invention so as to prevent the outer electromagnetic energy or the electromagnetic energy emitted from the source of Electro Magnetic Interference/Radio Frequency Interference from entering into the electronic/electric apparatus.

Although several preferred embodiments has been shown and described, it would be appreciated by those skilled in the art that changes may be made in these embodiments without departing from the principles of the invention, the scope of which is defined in the claims.

## Claims

1. A magnetic shielding gasket, comprising:
a conductive foam substrate (11) exhibiting resilience and recoverability and having a first surface;
a magnetic layer (15) attached to said first surface of the conductive foam substrate, the magnetic shielding aspect **characterized by**
the magnetic layer exhibiting magnetic permeability, wherein the initial magnetic permeability of the magnetic layer is greater than 1000 @ 0.1A/m and the maximum magnetic permeability of the magnetic layer is greater than 5000 @ 0.1A/m, and wherein a thickness of the magnetic layer is from 15 to 30 microns; and
by a structure reinforcing layer (23) made of conductive fabric, said structure reinforcing layer being attached to an outer surface of said magnetic layer, wherein a thickness of the structure reinforcing layer is greater than 0.05 mm but less than or equal to 0.15 mm.

2. The magnetic shielding gasket of Claim 1, wherein the initial magnetic permeability of the magnetic layer is greater than 80,000 @ 0.1A/m and the maximum magnetic permeability of the magnetic layer is greater than 400,000.

3. The magnetic shielding gasket of Claim 1, wherein the magnetic layer is attached to said first surface of the conductive foam substrate by a conductive adhesive.

4. The magnetic shielding gasket of Claim 1, wherein the structure reinforcing layer is attached to said surface of the conductive foam substrate by a conductive adhesive; and the magnetic layer is attached to the outer surface of the structure reinforcing layer by a conductive adhesive.

5. The magnetic shielding gasket of Claim 1, wherein the conductive foam substrate has an open-celled foam structure with pores distributed therein, wherein the open-celled foam structure has a pore density of 50-250ppi, preferably 60-150ppi, and more preferably 80-120ppi.

6. The magnetic shielding gasket of Claim 4, wherein the conductive foam substrate is formed by depositing a metal coating onto the open-celled foam structure, and the metal coating comprises at least one of Cu, Ni, Sn, Au, Ag, Co and Pd and the mixture thereof.

7. The magnetic shielding gasket of Claim 1, wherein the conductive foam substrate has a thickness of 0.5-10mm, preferably 1.0-3.0mm, more preferably 1.5-2.0mm in an uncompressed state.

8. The magnetic shielding gasket of Claim 1, wherein the magnetic layer is made of at least one of the group consisting of permalloy ribbon, nanocrystalline iron-based alloy ribbon, and Co-based amorphous alloy ribbon.

9. The magnetic shielding gasket of Claim 1, wherein the magnetic layer has a thickness or 10-100 µm, preferably 15-30 µm, and more preferably about 20 µm.

10. The magnetic shielding gasket of Claim 1, wherein the conductive fabric is formed by a mesh fabric subjected to a metal electroplating process.

11. The magnetic shielding gasket of Claim 1, wherein the surface resistivity of the gasket on the conductive foam substrate side is not greater than 0.05 ohm/sqr, and the contact resistance of the magnetic shielding gasket is not greater than 0.07 ohm/ square inch.

12. The magnetic shielding gasket of Claim 1, wherein the conductive foam substrate comprises at least one of polyurethane, polyvinyl chloride (PVC), silicone, ethylene-vinyl-acetate copolymer (EVA) bend, and polyethylene.

## Patentansprüche

1. Magnetische Abschirmdichtung, umfassend:
ein leitfähiges Schaumsubstrat (11), das Elastizität und Erholungsfähigkeit aufweist und eine erste Fläche hat;
eine Magnetschicht (15), die an der ersten Fläche des leitfähigen Schaumsubstrats befestigt ist, wobei die magnetische Abschirmdichtung **gekennzeichnet ist durch** die Magnetschicht, die eine magnetische Permeabilität aufweist, wobei die magnetische Anfangspermeabilität der Magnetschicht größer als 1000 bei 0,1 A/m und die magnetische Maximalpermeabilität der Magnetschicht größer als 5000 bei 0,1 A/m ist, und
wobei eine Dicke der Magnetschicht zwischen 15 und 30 Mikrometern liegt; und
**durch** eine Strukturverstärkungsschicht (23), die aus leitfähigem Gewebe hergestellt ist, wobei die Strukturverstärkungsschicht (23) an einer Außenfläche der Magnetschicht befestigt ist, wobei eine Dicke der Strukturverstärkungsschicht größer als 0,05 mm, aber kleiner oder gleich 0,15 mm ist.

2. Magnetische Abschirmdichtung nach Anspruch 1, wobei die magnetische Anfangspermeabilität der Magnetschicht größer als 80.000 bei 0,1 A/m ist und die magnetische Maximalpermeabilität der Magnetschicht größer als 400.000 ist.

3. Magnetische Abschirmdichtung nach Anspruch 1, wobei die Magnetschicht an der ersten Fläche des leitfähigen Schaumsubstrats durch einen leitfähigen Klebstoff befestigt ist.

4. Magnetische Abschirmdichtung nach Anspruch 1, wobei die Strukturverstärkungsschicht an der Fläche des leitfähigen Schaumsubstrats durch einen leitfähigen Klebstoff befestigt ist; und die Magnetschicht an der Außenfläche der Strukturverstärkungsschicht durch einen leitfähigen Klebstoff befestigt ist.

5. Magnetische Abschirmdichtung nach Anspruch 1, wobei das leitfähige Schaumsubstrat eine offenzellige Schaumstruktur mit Poren hat, die darin verteilt sind, wobei die offenzellige Schaumstruktur eine Porendichte von 50-250 ppi, vorzugsweise 60-150 ppi und am besten 80-120 ppi hat.

6. Magnetische Abschirmdichtung nach Anspruch 4, wobei das leitfähige Schaumsubstrat durch Abscheiden einer Metallbeschichtung auf der offenzelligen Schaumstruktur gebildet ist und die Metallbeschichtung mindestens ein Element aus Cu, Ni, Sn, Au, Ag, Co und Pd und der Mischung derselben umfasst.

7. Magnetische Abschirmdichtung nach Anspruch 1, wobei das leitfähige Schaumsubstrat eine Dicke von 0,5-10 mm, vorzugsweise 1,0-3,0 mm und besser 1,5-2,0 mm in einem unkomprimierten Zustand hat.

8. Magnetische Abschirmdichtung nach Anspruch 1, wobei die Magnetschicht aus mindestens einem Element aus der Gruppe bestehend aus Permalloy-Band, nanokristallinem Eisenlegierungsband und amorphem Co-Legierungsband hergestellt ist.

9. Magnetische Abschirmdichtung nach Anspruch 1, wobei die Magnetschicht eine Dicke von 10-100 µm, vorzugsweise 15-30 µm und besser etwa 20 µm hat.

10. Magnetische Abschirmdichtung nach Anspruch 1, wobei das leitfähige Gewebe durch ein Gewebe gebildet ist, welches einem Galvanisierungsprozess ausgesetzt wurde.

11. Magnetische Abschirmdichtung nach Anspruch 1, wobei der spezifische Oberflächenwiderstand der Dichtung auf der leitfähigen Schaumsubstratseite nicht größer als 0,05 Ohm/sqr ist und der Kontaktwiderstand der magnetischen Abschirmdichtung nicht größer als 0,07 Ohm/Quadratzoll ist.

12. Magnetische Abschirmdichtung nach Anspruch 1, wobei das leitfähige Schaumsubstrat mindestens ein Element aus Polyurethan, Polyvinylchlorid (PVC), Silikon, Ethylen-Vinylacetat-Copolymer(EVA)-Mischung und Polyethylen umfasst.

## Revendications

1. Joint de protection magnétique, comprenant :
un substrat de mousse conductrice (11) présentant une élasticité et une aptitude de récupération et comportant une première surface ;
une couche magnétique (15) fixée à ladite première surface du substrat de mousse conductrice, le joint de protection magnétique étant **caractérisé par** la couche magnétique présentant une perméabilité magnétique, la perméabilité magnétique initiale de la couche magnétique étant supérieure à 1000 à 0,1 A/m et la perméabilité magnétique maximale de la couche magnétique étant supérieure à 5000 à 0,1 A/m, et l'épaisseur de la couche magnétique étant de 15 à 30 µm ; et
par une couche de renforcement de structure (23) se composant d'un tissu conducteur, ladite couche de renforcement de structure étant fixée à une surface extérieure de ladite couche magnétique, l'épaisseur de la couche de renforcement de structure étant supérieure à 0,05 mm, mais inférieure ou égale à 0,15 mm.

2. Joint de protection magnétique selon la revendication 1, dans lequel la perméabilité magnétique initiale de la couche magnétique est supérieure à 80 000 à 0,1 A/m et la perméabilité magnétique maximale de la couche magnétique est supérieure à 400 000.

3. Joint de protection magnétique selon la revendication 1, dans lequel la couche magnétique est fixée à ladite première surface du substrat de mousse conductrice par un adhésif conducteur.

4. Joint de protection magnétique selon la revendication 1, dans lequel la couche de renforcement de structure est fixée à ladite surface du substrat de mousse conductrice par un adhésif conducteur, et la couche magnétique est fixée à la surface extérieure de la couche de renforcement de structure par un adhésif conducteur.

5. Joint de protection magnétique selon la revendication 1, dans lequel le substrat de mousse conductrice possède une structure de mousse à cellules ouvertes avec des pores distribués à l'intérieur, la structure de mousse à cellules ouvertes ayant une densité de pores de 50-250 ppi, de préférence 60-150 ppi, mieux 80-120 ppi.

6. Joint de protection magnétique selon la revendication 4, dans lequel le substrat de mousse conductrice est formé en déposant un revêtement métallique sur la structure de mousse à cellules ouvertes, et le revêtement métallique comprend au moins un élément parmi Cu, Ni, Sn, Au, Ag, Co et Pd, ou le mélange de ceux-ci.

7. Joint de protection magnétique selon la revendication 1, dans lequel le substrat de mousse conductrice a une épaisseur de 0,5-10 mm, de préférence 1,0-3,0 mm, mieux 1,5-2,0 mm dans un état non comprimé.

8. Joint de protection magnétique selon la revendication 1, dans lequel la couche magnétique se compose d'au moins un élément du groupe constitué par un ruban de permalloy, un ruban d'alliage nanocristallin à base de fer, et un ruban d'alliage amorphe à base de Co.

9. Joint de protection magnétique selon la revendication 1, dans lequel la couche magnétique a une épaisseur de 10-100 µm, de préférence 15-30 µm, mieux environ 20 µm.

10. Joint de protection magnétique selon la revendication 1, dans lequel le tissu conducteur est formé par un tissu maillé soumis à un procédé de dépôt électrolytique de métal.

11. Joint de protection magnétique selon la revendication 1, la résistivité de surface du joint sur le côté du substrat de mousse conductrice étant inférieure ou égale à 0,05 ohm/carré, et la résistance de contact du joint de protection magnétique étant inférieure ou égale à 0,07 ohm/pouce carré.

12. Joint de protection magnétique selon la revendication 1, dans lequel le substrat de mousse conductrice comprend au moins un élément parmi le polyuréthane, le polychlorure de vinyle (PVC), le silicone, le mélange de copolymère éthylène-acétate de vinyle (EVA), et le polyéthylène.
